# EUROPEAN PATENT APPLICATION

(11) **EP 1 962 417 A1**
(43) Date of publication of application: **27.08.2008**
(21) Application number: 07124165.7
(22) Date of filing: 28.12.2007
(51) Int. Cl.: H03F 1/02

(54) **Power supply device, signal output apparatus and power supply method**

(30) Priority: 22.02.2007 JP 2007042566
(71) Applicant: Fujitsu Ltd., Kawasaki-shi, Kanagawa 211-8588 (JP)
(72) Inventor: Hirahara, Minoru c/o FUJITSU LIMITED, Kawasaki-shi, Kanagawa 211-8588 (JP); Miyachika, Eiji c/o FUJITSU LIMITED, Kawasaki-shi, Kanagawa 211-8588 (JP); Miyoshi, Seiji c/o FUJITSU LIMITED, Kawasaki-shi, Kanagawa 211-8588 (JP); Koyama, Yoshito c/o FUJITSU LIMITED, Kawasaki-shi, Kanagawa 211-8588 (JP)
(74) Representative: Wilding, Frances Ward

(57) **Abstract**

A power supply device capable of suitably reducing a loss even in a case where power is supplied to an output device which outputs a high-frequency signal, a signal output apparatus in which a loss is suitably reduced, and a power supply method capable of suitably reducing a loss. The power supply device has a power supply section which supplies a power supply voltage to an output device which is supplied with the power supply voltage and outputs an output signal, and a voltage control section which controls the power supply section so that the power supply voltage follows the envelope of the output signal from the output device.

## Description

### BACKGROUND OF THE INVENTION

### Field of the Invention

The present invention relates to a power supply device which supplies a power supply voltage to an output device, a signal output apparatus which outputs a signal, and a power supply method of supplying a power supply voltage.

### Description of the Related Art

A power supply device which supplies a power supply voltage to an amplifier or a signal generator is conventionally known. The amplifier or the signal generator supplied with the power supply voltage from the power supply device is called a load device in a sense that the amplifier or the signal generator is a load on the power supply device. The amplifier or the signal generator is also a kind of output device in a sense that it outputs a signal.

A loss in the load device is proportional to the difference between the power supply voltage supplied to the load device and a signal voltage output from the load device. In view of this, a technique to reduce the loss by controlling the power supply voltage according to the signal voltage has been proposed. For example, Japanese Patent Laid-Open No. 2001-69241 discloses a ringer signal sending device which sends out a ringer signal. A power supply device incorporated in this ringer signal sending device changes a power supply voltage supplied to an amplifier circuit amplifying the ringer signal along a curve in synchronization with the amplitude of the ringer signal to reduce a loss in the amplifier circuit.

However, in a communication apparatus or the like for example, the frequency of the signal output by the load device is high. It can therefore be predicted that a direct application of the proposed conventional technique to an internal power supply will entail difficulty in synchronizing the power supply voltage with the signal, and it is thought that a suitable loss reduction effect cannot be achieved.

### SUMMARY OF THE INVENTION

The present invention has been made in view of the above circumstances and has an aim to provide a power supply device capable of suitably reducing a loss even in a case where power is supplied to an output device which outputs a high-frequency signal, a signal output apparatus in which a loss is suitably reduced, and a power supply method capable of suitably reducing a loss.

A power supply device according to the present invention which achieves the above aim includes a power supply section which supplies a power supply voltage to an output device which is supplied with the power supply voltage and outputs an output signal, and a voltage control section which controls the power supply section to cause the power supply voltage to follow the envelope of the output signal from the output device.

In the power supply device according to the present invention, the power supply voltage follows the envelope of the output signal from the output device. In correspondence with the extent of this following, the voltage difference between the power supply voltage and the output signal is reduced, thereby reducing the loss. In addition, in a communication apparatus or the like, the frequency of the envelope of the output signal is sufficiently low even if the output signal is a high-frequency signal, and the envelope can be followed by the power supply voltage, thus achieving a suitable loss reduction effect.

It is preferable that the power supply device according to the present invention has a form "wherein the output device receives an input signal and outputs an output signal of an intensity according to the signal intensity of the input signal, and
wherein the voltage control section controls the power supply voltage on the basis of the input signal which the output device receives, thereby causing the power supply voltage to follow the envelope of the output signal".

For example, in the case of an output device such as an amplifier which outputs an output signal of an intensity according to the signal intensity of an input signal, the output signal can be predicted from the input signal and, therefore, the envelope of the output signal can be obtained on the basis of the input signal. The power supply voltage is caused to follow the envelope obtained on the basis of the input signal. In this way, a time margin is produced in comparison with the case of causing the power supply voltage to directly follow the envelope of the output signal, thereby improving the following performance and improving the loss reduction effect.

It is also preferable that the power supply device according to the present invention has a form "wherein the power supply section includes:
a constant-voltage generation section which generates a constant voltage; and
a chopper section which receives a pulse signal and turns on and off the constant voltage generated by the constant-voltage generation section according to on and off states of the pulse signal to convert the constant voltage into the power supply voltage, and
wherein the voltage control section generates a pulse signal having an on/off ratio according to the envelope of the output signal and inputs the pulse signal having the on/off ratio to the chopper section in the power supply section".

In the power supply device in this preferable form, the power supply voltage is controlled by pulse width modulation (PWM) control or pulse frequency modulation (PFM) control. Therefore, stabilized highly accurate voltage control is realized. As a result, the following of the envelope by the power supply voltage is made more suitable and the loss reduction effect is improved.

A signal output apparatus according to the present invention which achieves the above aim includes a signal output section which is supplied with a power supply voltage and outputs an output signal, a power supply section which supplies the power supply voltage to the signal output section, and a voltage control section which controls the power supply section to cause the power supply voltage to follow the envelope of the output signal from the signal output section.

In the signal output apparatus according to the present invention, the power supply voltage follows the envelope of the output signal from the signal output section and, therefore, the voltage difference between the power supply voltage and the output signal is reduced, thereby reducing the loss as described above.

It is preferable that the signal output apparatus according to the present invention has a form "wherein the signal output section receives an input signal and outputs an output signal of an intensity according to the signal intensity of the input signal, and
wherein the voltage control section controls the power supply voltage on the basis of the input signal which the signal output section receives, thereby causing the power supply voltage to follow the envelope of the output signal".

The power supply voltage is caused to follow the envelope obtained on the basis of the input signal. In this way, a time margin is produced in comparison with the case of causing the power supply voltage to directly follow the envelope of the output signal, thereby improving the following performance and improving the loss reduction effect.

It is also preferable that the signal output apparatus according to the present invention has a form "wherein the power supply section includes:
a constant-voltage generation section which generates a constant voltage; and
a chopper section which receives a pulse signal and turns on and off the constant voltage generated by the constant-voltage generation section according to on and off states of the pulse signal to convert the constant voltage into the power supply voltage, and
wherein the voltage control section generates a pulse signal having an on/off ratio according to the envelope of the output signal and inputs the pulse signal having the on/off ratio to the chopper section in the power supply section".

In the signal output apparatus in this preferable form, the power supply voltage is controlled by PWM control or PFM control. Therefore, stabilized highly accurate voltage control is realized. As a result, the following of the envelope by the power supply voltage is made more suitable and the loss reduction effect is improved.

A power supply method according to the present invention which achieves the above aim includes an envelope acquisition step of directly or indirectly obtaining an envelope of an output device which is supplied with a power supply voltage and outputs an output signal, and a power supply step of supplying to the output device the power supply voltage following the envelope obtained in the envelope acquisition step.

According to the power supply method of the present invention, the power supply voltage follows the envelope of the output signal from the output device and, therefore, the voltage difference between the power supply voltage and the output signal is reduced, thereby reducing the loss as described above.

It is preferable that the power supply method according to the present invention has a form "wherein the output device receives an input signal and outputs an output signal of an intensity according to the signal intensity of the input signal, and wherein the envelope acquisition step is a step of indirectly obtaining the envelope of the output signal by obtaining the envelope of the input signal received by the output device".

For example, in the case of an output device such as an amplifier which outputs an output signal of an intensity according to the signal intensity of an input signal, the output signal can be predicted from the input signal and, therefore, the envelope of the output signal can be obtained on the basis of the input signal. The power supply voltage is caused to follow the envelope obtained on the basis of the input signal. In this way, a time margin is produced in comparison with the case of causing the power supply voltage to directly follow the envelope of the output signal, thereby improving the following performance and improving the loss reduction effect.

Thus, according to the present invention, a loss is suitably reduced.

### BRIEF DESCRIPTION OF THE DRAWINGS

Fig. 1 is a diagram showing a communication apparatus corresponding to an embodiment of a signal output apparatus of the present invention; and
Fig. 2 is a graph of a communication signal and a power supply voltage.

### DETAILED DESCRIPTION OF THE INVENTION

An embodiment of the present invention will be described with reference to the accompanying drawings.

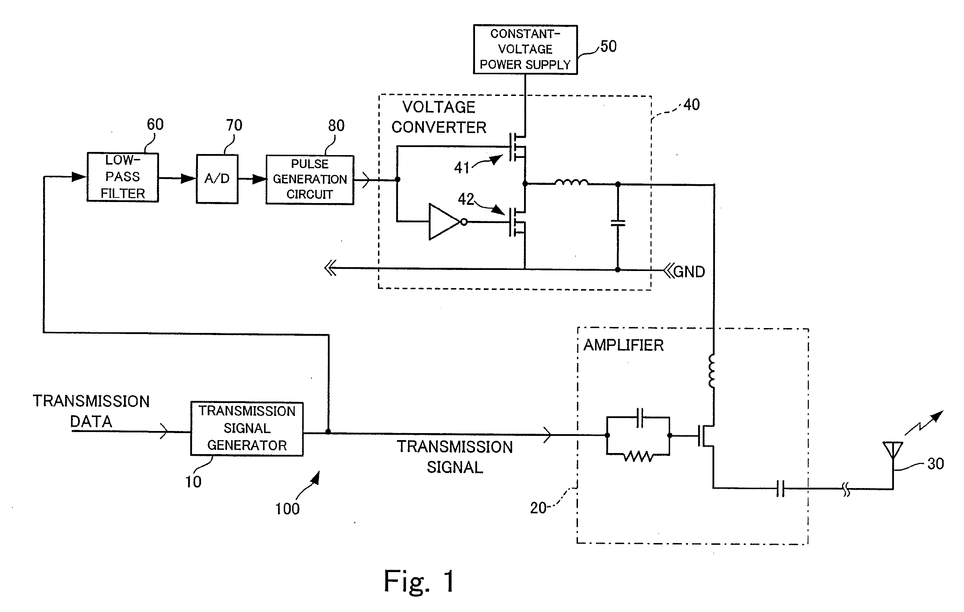

Fig. 1 is a diagram showing a communication apparatus corresponding to an embodiment of a signal output apparatus according to the present invention.

Fig. 1 outlines a communication apparatus 100 used as a base station in a portable telephone system. The communication apparatus 100 has a transmission signal generator 10 to which digital transmission data representing the contents of data to be transmitted is input and which generates an analog transmission signal representing the contents of data to be transmitted, an amplifier 20 which amplifies the transmission signal and outputs the amplified communication signal, an antenna 30 to which the communication signal is input and which emits an electric wave, a constant-voltage power supply 50, a voltage converter 40 which converts the voltage of the constant-voltage power supply 50 by so-called PWM and supplies the converted voltage to the amplifier 20, a low-pass filter 60, an AD converter 70 and a pulse generation circuit 80.

Here, the amplifier 20 corresponds to an example of the output device according to the present invention and to an example of the signal output section according to the present invention. The constant-voltage power supply 50 corresponds to an example of the constant-voltage generation section according to the present invention. The voltage converter 40 corresponds to an example of the chopper section according to the present invention. The constant-voltage power supply 50 and the voltage converter 40 constitute an example of the power supply section according to the present invention. The low-pass filter 60, the AD converter 70 and the pulse generation circuit 80 constitute an example of the voltage control section according to the present invention. Further, the constant-voltage power supply 50, the voltage converter 40, the low-pass filter 60, the AD converter 70 and the pulse generation circuit 80 constitute an embodiment of the power supply device according to the present invention.

The circuit configuration of the amplifier 20 and the voltage converter 40 shown in Fig. 1 represent not an actual configuration of the amplifier 20 and the voltage converter 40 but a configuration of a schematic equivalent circuit extremely simplified for ease of description.

In the conventional communication apparatus, a rated voltage is supplied to the amplifier 20. However, the difference between the supplied voltage supplied to the amplifier 20 and the voltage of a communication signal output from the amplifier 20 is a loss in the amplifier 20. In the communication apparatus 100 in the present embodiment, therefore, a mechanism for setting the voltage supplied to the amplifier 20 to a supplied voltage slightly higher than the voltage of the communication signal output from the amplifier 20 by causing the voltage supplied to the amplifier 20 to follow the communication signal is incorporated for the purpose of reducing power consumption. In the communication apparatus 100, however, not the output from the amplifier 20 itself but the transmission signal input to the amplifier 20 is used to cause the supplied voltage to follow the output in order to obtain a time margin for following the output from the amplifier 20. In the present embodiment, the fundamental frequency of the transmission signal and the communication signal is about 2 GHz and the envelope changes at about 20 MHz according to the contents of data to be transmitted. However, it is difficult to adjust the supplied voltage at 2 GHz and, therefore, the mechanism for causing the supplied voltage to follow the envelope of the communication signal is provided. This mechanism will be described below.

The transmission signal generated by the transmission signal generator 10 is input to the amplifier 20 and is also input to the low-pass filter 60. A filter of several ten MHz is used as the low-pass filter 60. The envelope of the transmission signal is extracted by means of the low-pass filter 60. The extracted envelope is sampled by the 2 GHz AD converter 70 and the sampled signal is sent to the pulse generation circuit 80. The pulse generation circuit 80 is a circuit for generating a pulse signal for controlling the power supply voltage by PWM control and inputting the pulse signal to the voltage converter 40. This circuit generates the pulse signal at a constant frequency by on-off control of the 2 GHz fundamental pulses. That is, one set of a predetermined number of fundamental pulses is defined; the region in front of the set is assumed to be "on" while the region in rear of the set is assumed to be "off"; and then the position of the boundary between "on" and "off" is adjusted to the position according to envelope sampled by the AD converter 70, thus adjusting the pulse width of the pulse signal. Since the frequency of the pulse signal is constant, the duty ratio, i.e., the on/off ratio, of the pulse signal is adjusted by the above-described pulse width adjustment. If the magnitude of the envelope of the transmission signal input to the amplifier 20 is known, the magnitude of the envelope of the communication signal output from the amplifier 20 can be obtained, because the amplification characteristics of the amplifier 20 are known. Also, the duty ratio of the pulse signal can be determined in advance so that the power supply voltage is slightly higher than the envelope of the communication signal. In the pulse generation circuit 80, the pulse width with respect to the magnitude of the envelope obtained from the AD converter 70 is set in advance in an association table on the basis of the above-described known relationship; the pulse width of the pulse signal is obtained at a high speed from the envelope of the transmission signal by using the association table, and the pulse signal having the pulse width thus determined is generated. The pulse signal generated in this way is input to the voltage converter 40.

In the voltage converter 40, two semiconductor switches 41 and 42 perform switching operations according to the pulse signal in a contrary relationship with each other. The constant-voltage power supply 50 is connected to the voltage converter 40. The constant-voltage power supply 50 is a power supply designed so as to stabilize the output voltage. A stabilized voltage is supplied from the constant-voltage power supply 50 to the voltage converter 40. This stabilized voltage is converted into a voltage according to the duty ratio of the pulse signal by the switching operations of the semiconductor switches 41 and 42, and the converted voltage is output from the voltage converter 40. In a circuit performing such a switching operation, feedback control of the output is ordinarily performed to stabilize the output. In the present embodiment, however, feedback is omitted because the voltage supplied to the voltage converter 40 is the stabilized voltage from the constant-voltage power supply 50. As a result, the output from the voltage converter 40 can follow at a high speed the envelope of the communication signal output from the amplifier 20.

Thus, a voltage which changes by following the envelope of the communication signal is supplied as a power supply voltage to the amplifier 20. The amplifier 20 amplifies the transmission signal on the basis of the power supply voltage changing as described above to output the communication signal.

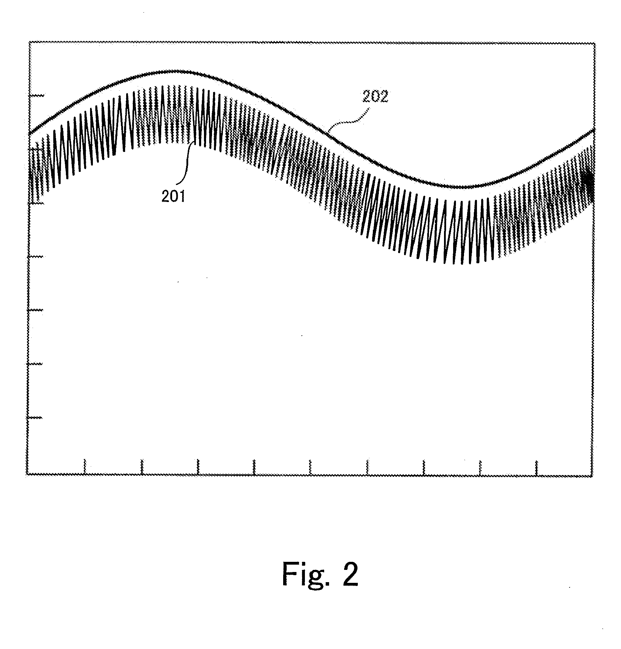

Fig. 2 is a graph of the communication signal and the power supply voltage.

The abscissa of this graph represents time and the ordinate represents voltage.

In this graph, communication signal 201 is shown and fine vibrations in the communication signal 201 correspond to the 2 GHz fundamental frequency. A line connecting peaks of the finely vibration in the communication signal 201 is the envelope of communication signal 201 changing largely in a cycle of about 20 MHz as described above.

In this graph, power supply voltage 202 is also shown above communication signal 201. It can be understood that this power supply voltage 202 follows the envelope of communication signal 201 and is slightly higher than the voltage of the envelope. This power supply voltage 202 is reduced as much as possible while leaving the least necessary margin for the operation of the amplifier 20 shown in Fig. 1. This power supply voltage 202 is supplied to the amplifier 20 to largely reduce the loss in the amplifier 20 and the loss in the communication apparatus 100.

While an example of the voltage control section according to the present invention in which the voltage is controlled by PWM control has been described, the voltage control section according to the present invention may be arranged to control the voltage by PFM control or to control the voltage by a control method not using the pulse signal.

Also, while an example of the voltage control section according to the present invention in which the power supply voltage is controlled on the basis of the input signal to the amplifier to cause the power supply voltage to follow the output signal has been described, the voltage control section according to the present invention may be arranged to directly use the output signal itself from the output device to cause the power supply voltage to follow the output signal.

Also, while a power supply device incorporated in a communication apparatus to supply a power supply voltage to an amplifier has been described as an embodiment of the power supply device of the present invention, the power supply device of the present invention may be arranged to supply a power supply voltage to a unit or a circuit other than the communication apparatus and the amplifier.

## Claims

1. A power supply device comprising:
a power supply section which supplies a power supply voltage to an output device which is supplied with the power supply voltage and outputs an output signal; and
a voltage control section which controls the power supply section to cause the power supply voltage to follow the envelope of the output signal from the output device.

2. The power supply device according to claim 1, wherein the output device receives an input signal and outputs an output signal of an intensity according to the signal intensity of the input signal, and
wherein the voltage control section controls the power supply voltage on the basis of the input signal which the output device receives, thereby causing the power supply voltage to follow the envelope of the output signal.

3. The power supply device according to claim 1, wherein the power supply section includes:
a constant-voltage generation section which generates a constant voltage; and
a chopper section which receives a pulse signal and turns on and off the constant voltage generated by the constant-voltage generation section according to on and off states of the pulse signal to convert the constant voltage into the power supply voltage, and
wherein the voltage control section generates a pulse signal having an on/off ratio according to the envelope of the output signal and inputs the pulse signal having the on/off ratio to the chopper section in the power supply section.

4. A signal output apparatus comprising:
a signal output section which is supplied with a power supply voltage and outputs an output signal;
a power supply section which supplies the power supply voltage to the signal output section; and
a voltage control section which controls the power supply section to cause the power supply voltage to follow the envelope of the output signal from the signal output section.

5. The signal output apparatus according to claim 4, wherein the signal output section receives an input signal and outputs an output signal of an intensity according to the signal intensity of the input signal, and
wherein the voltage control section controls the power supply voltage on the basis of the input signal which the signal output section receives, thereby causing the power supply voltage to follow the envelope of the output signal.

6. The signal output apparatus according to claim 4, wherein the power supply section includes:
a constant-voltage generation section which generates a constant voltage; and
a chopper section which receives a pulse signal and turns on and off the constant voltage generated by the constant-voltage generation section according to on and off states of the pulse signal to convert the constant voltage into the power supply voltage, and
wherein the voltage control section generates a pulse signal having an on/off ratio according to the envelope of the output signal and inputs the pulse signal having the on/off ratio to the chopper section in the power supply section.

7. A power supply method comprising:
an envelope acquisition step of directly or indirectly obtaining an envelope of an output device which is supplied with a power supply voltage and outputs an output signal; and
a power supply step of supplying to the output device the power supply voltage following the envelope obtained in the envelope acquisition step.

8. The power supply method according to claim 7, wherein the output device receives an input signal and outputs an output signal of an intensity according to the signal intensity of the input signal, and
wherein the envelope acquisition step is a step of indirectly obtaining the envelope of the output signal by obtaining the envelope of the input signal received by the output device.
